# EUROPEAN PATENT APPLICATION

(11) **EP 4 221 475 A1**
(43) Date of publication of application: **02.08.2023**
(21) Application number: 21871693.4
(22) Date of filing: 28.09.2021
(51) Int. Cl.: H05K 7/14, H05K 5/06

(54) **FIXING MEMBER FOR WATERPROOF SHELL, AND WATERPROOF SHELL**

(30) Priority: 28.09.2020 CN 202022175292 U
(71) Applicant: Sublue Underwater AI Co., Ltd, Tianjin 300457 (CN)
(72) Inventor: WEI, Jiancang, Tianjin 300457 (CN); TONG, Qing, Tianjin 300457 (CN); LI, Zhongrui, Tianjin 300457 (CN); TIAN, Shengcun, Tianjin 300457 (CN); WANG, Zhen, Tianjin 300457 (CN); XI, Jing, Tianjin 300457 (CN); KANG, Chunsheng, Tianjin 300457 (CN)
(74) Representative: Cabinet Netter
(86) International application number: PCT/CN2021/121453
(87) International publication number: WO 2022/063324

(57) **Abstract**

Disclosed are a fixing member in a waterproof case and a fixing member, wherein the fixing member is configured to fix an electronic device in the waterproof case and comprises: a main body having a shape adapting to a shape of an inner cavity of the waterproof case and assembled in the inner cavity of the waterproof case; and a fixing part arranged on the main body, which detachably installs and fixes the electronic device.

## Description

### Cross-Reference to Related Applications

The present disclosure claims all the benefits of the Chinese patent application No. 202022175292.6 filed on September 28, 2020 before the National Intellectual Property Administration of the People's Republic of China, entitled "Fixing Member in Waterproof Case and Waterproof Case", which is incorporated herein by reference in its entirety.

### Field

The disclosure relates to the technical field of underwater electronic devices, more specifically to a fixing member in a waterproof case and a waterproof case.

### Background

Underwater work and underwater entertainment are becoming more and more common in people's lives, and in this process, electronic devices such as mobile phones, electronic watches, tablet computers and cameras are often needed. Because of its high value and low waterproof level, such devices are usually packaged in a waterproof case when used underwater. Various electronic devices produced by different manufacturers have different shapes and sizes. After the same waterproof case is loaded with different electronic devices, there is a gap between the device and an inner wall of the waterproof case due to an unadapted size, so that the device can shake relative to the waterproof case. When the device is used underwater, the waterproof case is usually fixed by hand or a holder, and uncontrollable shake and displacement of the device in the waterproof case will cause inconvenience in use of some functions of the device. For example, when the device is used to take photos underwater, shake of the device will cause jitter and unclear of photos and videos.

In the related art, in order to fix the device in the waterproof case, a waterproof case for a specific device model can be customized to produce a waterproof case having a shape and size adapting to the device to be used, so that gaps between the device and the waterproof case in all directions can be reduced or even eliminated, thereby eliminating shake of the device in the waterproof case. However, the waterproof case cannot be used for other devices with different shapes and sizes and has low adaptability and a narrow application range.

In the related art, a device can be fixed on the inner wall of the waterproof case by directly using adhesive materials such as a double faced adhesive tape, which is not conducive to subsequent adjustment of a position and angle of the device, and a process of disassembling and assembling the device and cleaning the adhesive materials is cumbersome and inconvenient.

When the electronic device is used to take photos or videos underwater, some water will inevitably enter the sealed waterproof case, and the water may vaporize and forms mist on surfaces such as a lens and the inner wall of the waterproof case during use, thus affecting quality of the photos and videos.

When putting the device into the waterproof case, a user often make a mistake on a direction of feeding the device, which leads the waterproof case and device not to be used normally. It will take a lot of energy to remove the device and put the device into the waterproof case correctly, and a key opportunity of work and entertainment may be missed in an emergency.

### Summary

In an aspect, the present disclosure provides a fixing member configured to fix an electronic device in a waterproof case, comprising: a main body having a shape adapting to a shape of an inner cavity of the waterproof case and assembled in the inner cavity of the waterproof case; and a fixing part arranged on the main body and detachably installing and fixing the electronic device.

Thus, various devices with different sizes and models can be fixed on the fixing part of the fixing member, and the fixing member can be placed in the waterproof case together with the device. When in use, since the fixing member adapts to the waterproof case, the fixing member together with the device will not shake relative to the waterproof case.

In some embodiments, a periphery of the main body comprises one or more of a spacing plate, a locating slot and a limit protrusion, and the spacing plate, and the limit protrusion and the locating slot abut against an inner wall of the waterproof case or are coupled to corresponding structures inside the waterproof case.

Therefore, the spacing plate, the limit protrusion and the locating slot abut against an inner wall of the waterproof case or are coupled to corresponding structures inside the waterproof case, so that the movement of the fixing member in the waterproof case is limited.

In some embodiments, the fixing part comprises a fixing groove and a device fixing part, the fixing groove is provided in the main body, and the device fixing part is assembled and fixed to the fixing groove and detachably installs and fixes the electronic device.

Therefore, the device fixing part is assembled and fixed to the fixing groove, and is not easy to fall, lose or be misplaced. The device fixing part can be repeatedly connected with and fixed to the device and conveniently detached, so that practicability of the fixing member is improved. In this way, the fixing member can be used repeatedly for a period of time without replacing parts or carrying out extra maintenance, which is convenient for a user to use and improves durability of the fixing member.

In some embodiments, the device fixing part is a removable adhesive. A first face of the removable adhesive is stuck in the fixing groove, and a second face of the removable adhesive is stuck and connected with a corresponding surface of the device.

Therefore, the first face of the removable adhesive is fixedly stuck in the installation groove in long term, and a device to be fixed can be fixed only by sticking and pressing the second face of the movable adhesive before use, which is convenient for operation. After use, they can be separated by force without affecting normal use of the device. The movable adhesive has large adhesion, which can keep the device firm in the fixing member and not falling off. When the movable adhesive is used for a long time and the bonding force is insufficient, adhesion can be restored by washing and airing, which is easy to operate and can be used repeatedly.

In some embodiments, the fixing member can be further provided with an anti-mist member. The anti-mist member comprises a water-absorbing member; or, the anti-mist member comprises a demisting agent release member.

Therefore, when water drops accidentally enter the waterproof case and mist is formed on an inner side of the waterproof case when in use, since the waterproof case cannot be opened to wipe all surfaces in the waterproof case when in use, the anti-mist member can play a role at this time. The water-absorbing member absorbs moisture in the waterproof case, and the demisting agent release member releases chemicals for removing water mist, thus preventing generation of mist. Therefore, when a user uses functions such as taking pictures and videos with the device, no mist will be formed in the waterproof case, and the user can obtain better experience.

In some embodiments, the fixing member can further comprise a window corresponding to a photosensitive area of the device. The window is a hole or a transparent material. Therefore, the fixing member will not block or affect work of the lens and other photosensitive elements on the device, which brings better user experience.

In some embodiments, the transparent material is an anti-mist and dust-proof transparent material. Therefore, it is possible to prevent the mist or dust on the transparent material from blocking a visual field and affecting light propagation, thus affecting smooth reception of an external light image by the photosensitive area of the device.

In some embodiments, the fixing member further comprises a fool-proofing structure corresponding to a shape, to which an inside of the waterproof case adapts, for fool-proofing positioning. The fool-proofing structure reminds a user of assembly error when the user puts the fixing member into the waterproof case in a wrong way, thus prompting the user to adjust the way of assembly until assembly is in place. Therefore, the fixing member can be placed in a correct position in the waterproof case with a correct posture and direction, and the user does not need to intentionally distinguish obverse and reverse postures of the fixing member when put in the waterproof case during installation, and does not need to worry about whether the assembly is wrong after installing the fixing member.

In some embodiments, the fool-proofing structure extends for a certain distance in a thickness direction of the device. Therefore, when the waterproof case is inserted from the wrong direction of the main body, since a thickness of the fool-proofing structure is larger than a size of the inner cavity of the waterproof case, the fixing member will get stuck at the opening of the cavity and cannot be sent into the waterproof case. The user then adjusts the entering posture and direction of the fixing member until the device and the fixing member are successfully sent into the waterproof case and the waterproof case is closed. The user does not need to worry about whether the posture and direction is correct after feeding, which improves the user experience.

### Brief Description of the Drawings

Accompanying drawings herein, which are incorporated in the description and constitute a part of the description, illustrate examples according to the disclosure and serve to explain principles of the disclosure together with the description.

In order to clearly illustrate technical solutions of the disclosure, drawings that need to be used in the disclosure are briefly introduced below, and it will be apparent to those of ordinary skill in the art that other drawings can be obtained based on these drawings without inventive work.
Fig. 1 is a schematic front structural view of a fixing member provided in one example of the present disclosure.
Fig. 2 is a schematic side structural view of a fixing member provided in one example of the present disclosure.
Fig. 3 is a schematic top structural view of a fixing member provided in one example of the present disclosure.
Fig. 4 is a schematic front structural view of a fixing member provided in one example of the present disclosure in an assembled state of being placed in a waterproof case.
Fig. 5 is a schematic side structural view of a fixing member provided in one example of the present disclosure in an assembled state of being placed in a waterproof case.
Fig. 6 is a schematic top structural view of a fixing member provided in one example of the present disclosure in an assembled state of being placed in a waterproof case.
Fig. 7 is a sectional view along an A-A direction of a fixing member provided in one example of the present disclosure in an assembled state of being placed in a waterproof case.
Fig. 8 is a sectional view along a B-B direction of a fixing member provided in one example of the present disclosure in an assembled state of being placed in a waterproof case.

Wherein, 1: main body, 2: fixing part, 3: anti-mist member, 4: handle, 5: fool-proofing structure, 6: window, 7: waterproof case, 8: through hole, 11: spacing plate, 12: locating slot, 13: limit protrusion.

### Detailed Description

In order to make objects, technical solutions, and advantages of examples of the disclosure clearer, the technical solutions in the examples of the disclosure will be clearly and fully described in combination with the accompanying drawings in the examples of the disclosure. Obviously, the examples to be described are part of examples but not all examples of the disclosure. Based on the examples in the disclosure, all other examples obtained by those of ordinary skill in the art without inventive work shall fall within the scope of the disclosure.

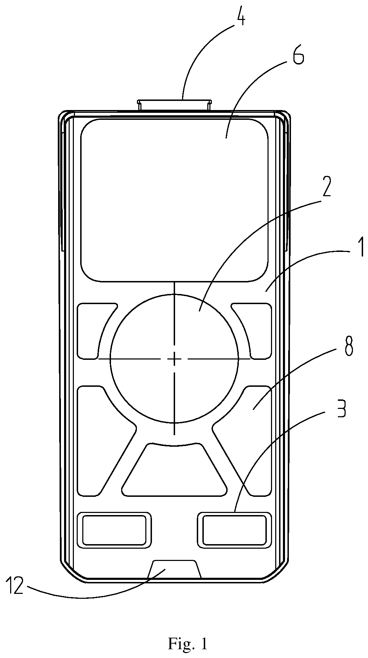

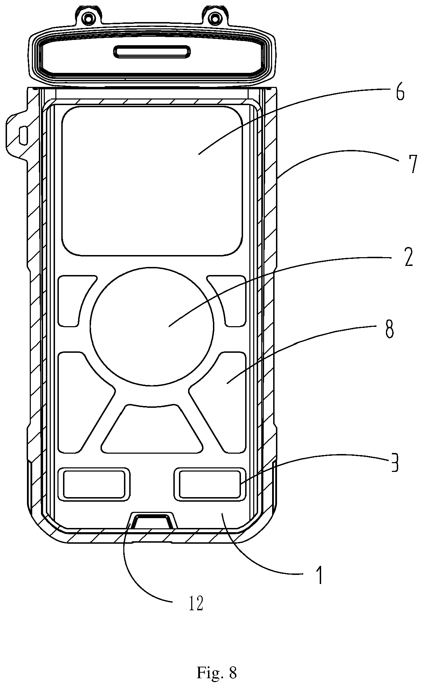

It should be noted that in the Description, descriptions of positional terms such as "front", "rear", "left", "right", "upper" and "lower" are all based on a position state of a fixing member as shown in Fig. 1 and Fig. 8.

The disclosure is to solve problems in the related art that when a waterproof case is used for electronic devices with different sizes and models, a device is easy to shake in the waterproof case, which affects some functions of the device and use experience of a user, and a common fixing measure in the related art have many shortcomings, such as inconvenient disassembly and assembly and a narrow application range. A main object of the disclosure is to provide convenience for fixing and normal use of various electronic devices in a waterproof case, so as to improve user experience.

With popularization of electronic devices and extension of various underwater activities of humans, more and more people put an electronic device in a waterproof case for underwater use. However, when a waterproof case with a single size is used with different devices, the electronic device will shake in the waterproof case due to a difference in size. Instability of the device will affect many functions of the device, such as taking photos and videos. Device fixing methods and opening design methods of waterproof cases in the related art are inconvenient for a user to disassemble, assemble and maintain the device in the waterproof case, especially when the opening of the waterproof case is small.

In an example of the disclosure, a fixing member for a device in a waterproof case is mainly provided, and the fixing member will not shake when put in the waterproof case. Devices with various models and sizes can be fixed on the fixing member and put into the waterproof case together with the fixing member, the fixing member will not shake relative to the waterproof case, and the device cannot move when stuck on the fixing member, so shake will not occur between the waterproof case and the device. Therefore, an application range of the waterproof case and stability of the device are improved, which is convenient for a user to use.

It can be understood by those skilled in the art that a main technical feature of the disclosure is to provide an intermediate fixing member which is easy to be fixed in the waterproof case due to structure and size thereof and is convenient to enter and exit the waterproof case; at the same time, the device is fixed on a main body of the fixing member by another fixing part arranged on the fixing member. Therefore, various devices with different sizes and models are fixed in the waterproof case with the fixing member as a medium. Therefore, variations of various technical solutions based on the above characteristics should be considered as belonging to a technical creative scope of the disclosure.

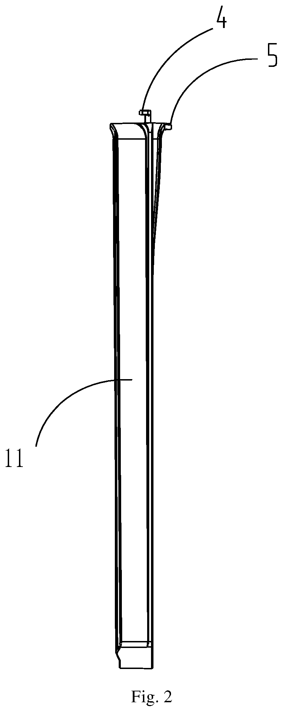

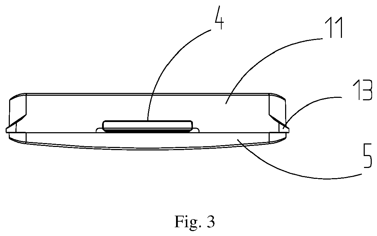

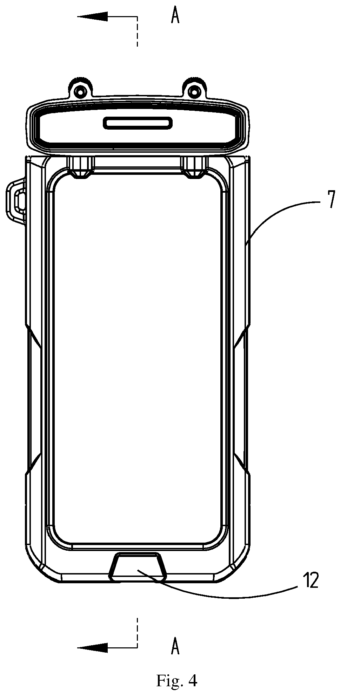

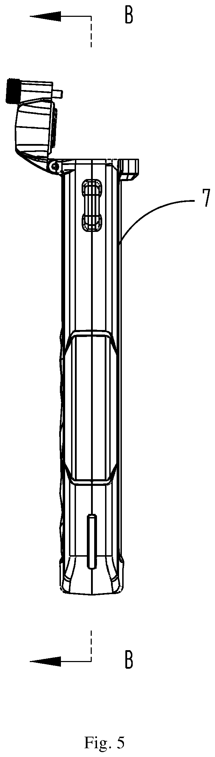

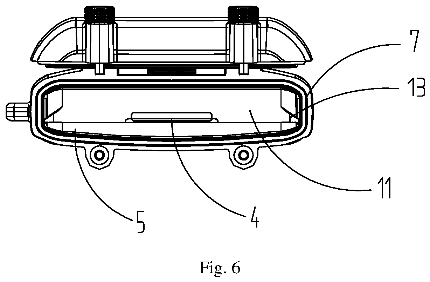

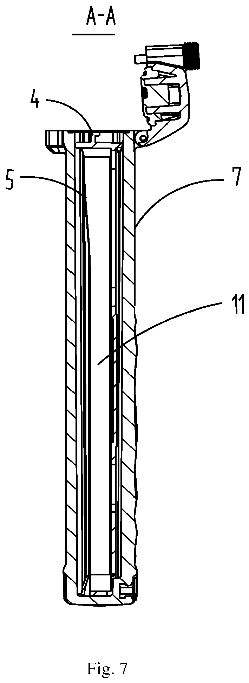

Referring to Figs. 1 to 8, Fig. 1 is a schematic front structural view of a fixing member provided in one example of the present disclosure; Fig. 2 is a schematic side structural view of a fixing member provided in one example of the present disclosure; Fig. 3 is a schematic top structural view of a fixing member provided in one example of the present disclosure; Fig. 4 is a schematic front structural view of a fixing member provided in one example of the present disclosure in an assembled state of being placed in a waterproof case; Fig. 5 is a schematic side structural view of a fixing member provided in one example of the present disclosure in an assembled state of being placed in a waterproof case; Fig. 6 is a schematic top structural view of a fixing member provided in one example of the present disclosure in an assembled state of being placed in a waterproof case; Fig. 7 is a sectional view along an A-A direction of a fixing member provided in one example of the present disclosure in an assembled state of being placed in a waterproof case; and Fig. 8 is a sectional view along an B-B direction of a fixing member provided in one example of the present disclosure in an assembled state of being placed in a waterproof case.

Referring to Fig. 1, in an example of the disclosure, provided is a fixing member configured to fix a device in a waterproof case 7, which comprises: a main body 1 having a shape adapting to a shape of an inner cavity of the waterproof case and assembled in the inner cavity of the waterproof case; and a fixing part 2 fixed to the main body 1, which detachably fixes the device.

The fixing part 2 comprises a fixing groove and a device fixing part. The fixing groove is provided in the main body, and the device fixing part is assembled and fixed to the fixing groove and detachably installs and fixes the electronic device. The device fixing part is fixed in the fixing groove in long term and is configured to detachably connect the electronic device to be fixed. A user can take down and reattach the device at will to adjust the position and angle of the device until the best state expected by the user.

In some embodiments, the fixing groove can be provided on the main body, or can be a separate part and is fixed on the main body by means of fixed connections such as bolt and welding. The disclosure is not limited in this respect.

In some embodiments, the device fixing part can be fixedly connected in the fixing groove or fixed in the fixing groove in a movable way as long as the connection between the device fixing part and the fixing groove is sufficiently tight and not easy to fall off. The disclosure is not limited in this respect.

In some embodiments, the fixing part 2 does not comprise a fixing groove, and the device fixing part can be directly connected and fixed on the main body 1 of the fixing member as long as the connection is sufficiently firm and not easy to be displaced or fall off. The disclosure is not limited in this respect.

In an example of the disclosure, the fixing part 2 is circular and is arranged in the middle of the main body 1. In some examples, the fixing part 2 can be in other shapes, or can be dispersed in parts of the main body, and each dispersed part can be detachably connected with the device to fix the device. The disclosure is not limited in this respect.

In some embodiments, the device fixing part in the fixing part 2 is a removable adhesive, a first face of the removable adhesive is stuck in the fixing groove, and a second face of the removable adhesive is stuck and connected with a corresponding surface of the electronic device. The first surface of the removable adhesive can be bonded to the main body 1 of the fixing member by either traditional bond or removable bond as long as the removable adhesive has sufficient bonding force and will not fall off when in use, and the disclosure does not limit this.

A second surface of the removable adhesive is used for detachably fixing the electronic device. During assembly, the electronic device is placed on the second surface of the removable adhesive and pressed downward. During disassembly, the fixing member and the electronic device are separated by forcibly pulling them in opposite directions. The bonding force of the removable adhesive will not be lost after one use, but will gradually weaken after a period of use, and can be restored after being treated by washing with water or other methods. Those skilled in the art can choose a suitable removable adhesive such as a nano-adhesive according to factors such as required bonding force, peeling force, and a bonding surface material to be applied. The second surface of the nano-adhesive is made of a modified polymer resin material (e.g., polyether polyol) and attached to a corresponding surface of the device which can be washed, traceless and reused; the first surface of the nano-adhesive is fixed in the fixing groove by PET and an acrylic tape (e.g., polyethylene terephthalate plastics).

In some embodiments, the fixing part 2 can be several buckles, and a relative distance and orientation between them and a clamping depth of the buckle are adjusted on the fixing member by screwing or other means so as to fix the device on the fixing part and to repeatedly disassemble the electronic device conveniently. Those skilled in the art can fix the device on the main body 1 by various fixing parts in a present common way. The disclosure is not limited in this respect.

After assembly, the fixing member is put into the waterproof case 7, and after a case cover is covered, the fixing member abuts against the inner wall of the waterproof case 7 from all directions with the size and shape adapting to the waterproof case 7, so that the fixing member cannot shake in the waterproof case 7. Since the device is fixed on the fixing member, the device will not shake in the waterproof case 7.

In an example of the disclosure, the fixing member can further comprise a handle 4, which is convenient for removing the fixing member from the waterproof case 7.

In an example of the disclosure, a spacing plate 11 extends in the thickness direction around the main body 1 of the fixing member, has a width adapting to the inner cavity of the matched waterproof case 7, and abuts against front and rear inner walls of the waterproof case 7 to limit movement of the fixing member in a front-rear direction; the spacing plate 11 extends in a left-right direction to abut against left and right inner walls of the inner cavity of the waterproof case 7, left and right sides above the main body 1 of the fixing member are provided with limit protrusions 13 (Fig. 6), and a middle position of a lower edge of the main body is provided with a locating slot 12 (Fig. 8), which are configured to limit a relative position relationship between the fixing member and the waterproof case 7 in the left-right direction and limit movement of the fixing member in the waterproof case 7 in the left-right direction; the spacing plate 11 extends in an upper-lower direction for a certain distance to abut against a bottom inner wall of the waterproof case 7 and an inner wall of the case cover when the case cover is closed, and the handle 4 can also abut against the inner wall of the case when the case cover is closed, thereby limiting vertical movement of the fixing member in the waterproof case 7. After the movement in the front, rear, left, right, upper, and lower directions of the fixing member in the waterproof case 7 is limited, the fixing member will not shake in the waterproof case 7.

Wherein, the disclosure does not limit a common arrangement design of the position, shape, and quantity of the spacing plate 11, the locating slot 12 and the limit protrusion 13 and whether the spacing plate 11, the locating slot 12 and the limit protrusion 13 are integrated with the main body 1 or separated from the main body and fixedly connected in a certain form, as long as the movement of the fixing member in the waterproof case 7 can be restricted in each direction. All other examples obtained by those of ordinary skill in the art without inventive work shall fall within the scope of the disclosure.

A manner of fixing the fixing member in the case 7 can adopt a size adapted design, so that all surfaces of the fixing member abut against the inner wall of the case 7; and can adopt a structure design, a mechanical structure commonly used in the related art such as a spring buckle is configured to lock and fix the fixing member as long as the locking and fixing structure can be repeatedly fixed and disassembled by the fixing member. The disclosure is not limited in this respect.

In some embodiments, the main body 1 can be further provided with an anti-mist member 3 which can achieve the purpose of anti-mist through different principle ways. For example, it is possible to absorb moisture, release a demisting agent or providing electric potential energy as long as the moisture in the waterproof case 7 can be eliminated or some substances or energy can be released in other ways to prevent mist from forming on surfaces such as a lens and the waterproof case 7. The disclosure is not limited in this respect.

In some embodiments, the main body 1 can further comprise a window 6, so that a photosensitive element of the device can successfully obtain information of a clear external image without being affected or blocked. The window 6 can be an empty hole or a transparent material as long as it can give enough vision and light to the photosensitive element on the device. The disclosure is not limited in this respect.

In some embodiments, the transparent material used in the window 6 can filter, strengthen, concentrate, and transform a light source signal of an optical sensor according to a characteristic of receiving a light signal by the device, using a special uneven structure such as a concave-convex lens and according to needs of a user. The disclosure is not limited in this respect.

In some embodiments, the one or more windows 6 can be provided on the fixing member according to the position of the photosensitive element of the mainstream device. The disclosure is not limited in this respect.

In some embodiments, the photosensitive part of the device can comprise a photoresistor, a brightness sensor, an infrared sensor, a camera assembly, and the like. The disclosure is not limited in this respect.

One example of the disclosure further comprises a fool-proofing structure 5 located at one side of the main body 1. Wherein, a size of the fool-proofing structure 5 adapts to the shape and size of the opening of the waterproof case 7, and when the fixing member is inserted from a tail side of the waterproof case 7, the fool-proofing structure 5 is stuck at the opening, so that the fixing member cannot be inserted into the waterproof case.

In some embodiments, the fool-proofing structure 5 can be integrated with the main body 1, or can be a part separate from the main body 1 and is installed on the main body. The disclosure is not limited in this respect.

In some embodiments, as described in one example of the disclosure, the fool-proofing structure 5 can be designed in size and shape to prevent wrong installation. A user can clearly and conveniently recognize a correct installation and fixing state and direction of the fixing member and adjust them by means of color, touch, voice prompt and the like, so as to prevent wrong installation. The disclosure is not limited in this respect.

In some embodiments, the fixing member can further comprise one or more through-holes 8, which is convenient for applying pressure to the device when disassembling the device.

In one embodiment provided in the disclosure, the waterproof case comprises the above-mentioned fixing member, and an outer case of the waterproof case adapts to the fixing member. The fixing member is restricted from moving in the case, different electronic device can be used underwater through the waterproof case, and the waterproof case can prevent water inflow to damage the electronic device; prevent the electronic device from shaking in the waterproof case to affect use; and avoid electronic devices with slightly different sizes and shapes adapting to and fixed in the waterproof case and reducing the application range of the waterproof case.

It should be noted that relationship terms such as "first" and "second" are used solely for distinguishing one entity or operation from another entity or operation herein without necessarily requiring or implying any actual relationship or order among the entities or operations. Furthermore, the terms "comprise", "comprising", or any other variants thereof are intended to encompass non-exclusive inclusion, so that a process, method, article, or device comprising a series of elements not only comprises those elements but further comprises other elements not expressly listed or elements inherent to such a process, method, article, or device. Without more limitations, an element defined by a phrase "comprise" does not exclude the presence of additional identical elements in the process, method, article, or device that comprises the element.

The foregoing description is only the description of embodiments of the disclosure to enable a person skilled in the art to understand or implement the disclosure. Various modifications to these examples will be apparent to a person skilled in the art, and general principles defined herein can be implemented in other examples without departing from the spirit or scope of the disclosure. Thus, the present disclosure is not limited to the examples shown in the disclosure, but conforms to the widest scope consistent with the principles and novel characteristics disclosed in the disclosure.

## Claims

1. A fixing member in a waterproof case, comprising:
a main body, having a shape adapting to an inner cavity of the waterproof case and assembled in the inner cavity of the waterproof case; and
a fixing part, arranged on the main body and detachably installing and fixing an electronic device.

2. The fixing member of claim 1, wherein a periphery of the main body comprises one or more of a spacing plate, a locating slot and a limit protrusion, and the spacing plate, and the limit protrusion and the locating slot abut against an inner wall of the waterproof case or are coupled to corresponding structures inside the waterproof case.

3. The fixing member of claim 1 or 2, wherein the fixing part comprises a fixing groove and a device fixing part, the fixing groove is provided in the main body, and the device fixing part is assembled and fixed to the fixing groove and detachably installs and fixes the electronic device.

4. The fixing member of claim 3, wherein the device fixing part is a removable adhesive, a first face of the removable adhesive is stuck in the fixing groove, and a second face of the removable adhesive is stuck and connected with a corresponding surface of the electronic device.

5. The fixing member of any one of claims 1 to 4, further comprising an anti-mist member fixed to the main body,
wherein the anti-mist member comprises a water-absorbing member, or, the anti-mist member comprises a demisting agent release member.

6. The fixing member of any one of claims 1 to 5, wherein the main body further comprises a window corresponding to a photosensitive area of the electronic device.

7. The fixing member of claim 6, wherein the window is a hole, or, the window is a transparent material, or, the window is an anti-mist and dust-proof transparent material.

8. The fixing member of any one of claims 1 to 7, further comprising a fool-proofing structure corresponding to a shape, to which an inside of the waterproof case adapts,, for fool-proofing positioning.

9. The fixing member of claim 8, wherein the fool-proofing structure extends for a certain distance in a thickness direction of the electronic device.

10. A waterproof case, comprising a case and the fixing member of any one of claims 1 to 9.
